# EUROPEAN PATENT SPECIFICATION

(11) **EP 0 453 812 B1**
(45) Date of publication and mention of the grant of the patent: **28.05.1997**
(21) Application number: 91104995.5
(22) Date of filing: 28.03.1991
(51) Int. Cl.: G11C 16/06, G11C 7/00

(54) **Worldline driver circuit for nonvolatile memory cell array**
Wortleitungstreiberschaltung für nichtflüchtiges Speicherzellenarray
Circuit d'attaque de ligne de mot pour réseau de cellule de mémoire non volatile

(30) Priority: 23.04.1990 US 513534
(43) Date of publication of application: 30.10.1991
(73) Proprietor: TEXAS INSTRUMENTS INCORPORATED, Dallas Texas 75265 (US)
(72) Inventor: Schreck, John F., Houston, Texas 77096 (US); Truong, Phat C., Houston, Texas 77083 (US); Ashmore, Benjamin H., Jr., Houston, Texas 77583 (US); Steigler, Harvey J., Houston, Texas 77072 (US)
(74) Representative: Leiser, Gottfried, Dipl.-Ing.

(56) References cited:
- EP-A- 0 356 650
- DE-A- 3 635 344
- US-A- 4 884 240

## Description

### BACKGROUND OF THE INVENTION

This invention relates to a non-volatile memory device comprising a wordline and a circuit for applying reading, programming and erasing voltages to said wordline and, therefore, to the control gates of nonvolatile memory cells such as floating-gate-type, electrically-erasable, electrically-programmable, read-only-memory (EEPROM) cells.

This application discloses and claims circuitry that is related to the wordline driver circuitry described in US-A-4,820,941, issued April 11, 1989; in US-A-4,823,318, issued April 18, 1989; and in US-A-5 265 052 all of which are assigned to Texas Instruments Incorporated.

EEPROM arrays of the type used with the circuitry of this application are described, for example, in US-A-5 008 721 and US-A-5 012 307, all of which being assigned to Texas Instruments Incorporated. EEPROM arrays of the type described in the foregoing applications require circuitry that will switch as many as four different values of voltage to each wordline for the purposes of reading, programming and erasing information stored on the floating gates. One of those voltages, the erasing voltage, must be negative with respect to the array bitlines or cell source-drain regions.

The various EEPROM wordline voltages may be generated from the external supply voltage Vcc (approx. +5V) using charge-pumped capacitors located on the memory chip. Circuits for switching from one positive voltage to a second positive voltage are well-known. For example, circuits for changing the wordline voltage from one value of positive voltage to another value of positive voltage, and even to reference voltage, have been used during the change from program-mode to read-mode of operation of electrically-programmable read-only-memories (EPROMs). However, in the case of EEPROMs, there is a need for improved circuits that will not only switch wordline reading and programming voltages, but that will also switch negative erasing voltages to a selected wordline. Switching of negative voltages presents a unique problem in that such circuits must be designed to prevent P-N junctions between the diffused areas and the substrate of such integrated circuits from becoming forward-biased during application of negative erase voltages.

In addition, there is a need for circuitry that will supply a third value of positive voltage to deselected wordlines during program-mode operation and, therefore, that decreases the probability of disturbing the programmed status of deselected memory cells.

Generally, the field-effect transistors used to drive wordlines during programming and/or erasing of memory cells must have a longer channel length than that of the field-effect transistors used during reading of those memory cells. The longer channel-lengths are required to prevent "punch-through" between source and drain caused by the higher voltages used during programming and erasing. In general, transistors with longer channels have slower operating times than transistors with shorter channels. Because previous wordline driver circuits have used at least some of the same driver transistors for both read-mode and for write- and/or erase-mode operations, the speed of operation during read-mode operation has been limited by the required longer channel length of those same transistors.

Also generally, the field-effect transistors used to drive wordlines during programming and/or erasing of memory cells must have thicker gate insulation than that of the field-effect transistors used during reading of those memory cells. The thicker gate insulation is required to prevent "field-plate" or "gated-diode" electric-field breakdown between gate conductor and the substrate caused by the higher voltages used during programming and erasing.

In EP-A-0 356 650 a circuit for applying reading, programming and erasing voltages to a wordline in a floating-gate-type EEPROM cell array is disclosed. In this circuit no separate pass to the wordline for read and programming voltages are provided so that it is not possible to optimize each pass for its particular purpose.

### SUMMARY OF THE INVENTION

The non-volatile memory device of this invention is provided with the features of claim 1.

The read-driver subcircuit may be constructed primarily using short-channel transistors for relatively high-speed operation when connected to high-capacitance wordlines. On the other hand, the program- and erase-driver subcircuits may be constructed using relatively long-channel transistors, perhaps with relatively thick gate-insulation. The transistors of the program and erase subcircuits may be located remotely on the memory chip from the memory cells and from the read-driver subcircuit, removing channel-length limitations in the memory-cell area, as well as allowing layout flexibility for purposes including isolation and use of thick-field devices. P-channel isolating transistors are used to switch the outputs of the subcircuits to the wordline, connecting the subcircuit in use and isolating the unused subcircuits during operations.

The program-driver subcircuit includes a voltage-translator subcircuit having a configuration that allows a lower required field-plate, or gated-diode breakdown voltage for the field-effect transistors used in that subcircuit. Therefore, the transistors of that subcircuit may be constructed with relatively short channel-lengths and relatively thin gate insulators.

The circuit of this invention is of particular usefulness when used in conjunction with a segmented memory array such as that described in US-A-5 313 432 filed May 3, 1990 and also assigned to Texas Instruments Incorporated.

### BRIEF DESCRIPTION OF THE DRAWINGS

The novel features of this invention are set forth in the appended claims. The invention, its features, and its advantages are described below in conjunction with the following drawings:

FIG. 1 illustrates a schematic diagram, in partial block form, of an exemplary nonvolatile memory array and associated circuitry that may include the wordline driver circuit of this invention.

FIG. 2 illustrates a schematic embodiment of the wordline driver circuit of this invention.

### DETAILED DESCRIPTION OF THE SPECIFIC EMBODIMENT

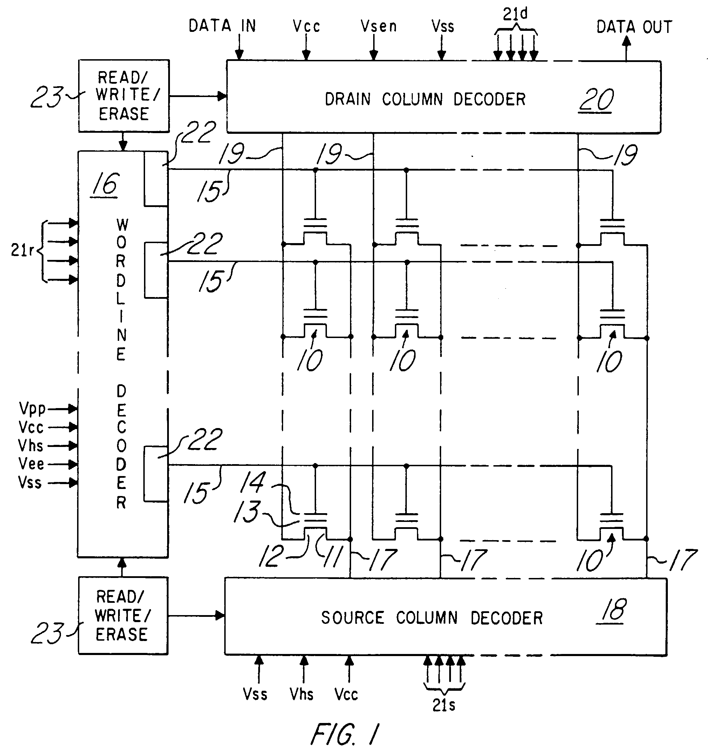

Referring to FIG. 1, an exemplary array of memory cells, which is an integral part of a memory chip, is shown for the purpose of illustrating use of the circuit of this invention. Each cell is a floating-gate transistor 10 having a source 11, a drain 12, a floating gate 13 and a control gate 14. Each of the control gates 14 in a row of cells 10 is connected to a wordline 15, and each of the wordlines 15 is connected to a wordline decoder 16. Each of the source electrodes 11 in a column of cells 10 is connected to a source-column line 17 (bitline), and each of the source-column lines 17 is connected to a source-column decoder 18. Each of the drain electrodes 12 in a column of cells 10 is connected to a drain-column line 19 (bitline), and each of the drain-column lines 19 is connected to a drain-column decoder 20.

In program-mode operation, the wordline decoder 16 may function, in response to wordline address signals on lines 21r, to place a preselected first programming voltage Vpp (approx. +16 to +18V) on a selected wordline 15, including a selected control-gate conductor 14 of the selected cell 10. Drain-column decoder 20 functions, in response to bitline-address signals on lines 21d, to place a preselected second programming voltage (reference potential Vss or ground, or a non-negative voltage) on a selected drain-column line 19, which includes the drain region 12 of the selected cell 10. The wordline decoder 16 may, optionally and in response to wordline-address signals on lines 21r, place a third preselected voltage Vhs (approx. +7V) on deselected wordlines 15, including deselected control-gate conductors 14 of the deselected cell 10. The third preselected voltage, or "half-select" voltage, Vhs should be sufficiently close to the second programming voltage that the floating-gate conductors 13 associated with the deselected wordlines 15 will not be programmed as a result, but should be sufficiently high that stress will be reduced across any tunnelling windows of cells in deselected wordlines 15, thereby avoiding de-programming of pre-programmed cells 10. Drain-column decoder 20 may also function to place a fourth preselected voltage, which may also be Vhs, on deselected drain-column lines 19. Source-column decoder 18, in response to bitline-address signals on lines 21s, functions to allow the selected source-column line 17 to float and may also function to place the fourth preselected voltage on deselected source-column lines 17. (In general, it is not necessary to place the fourth preselected voltage on both the source-column and the drain-column lines.) The positive voltage Vpp applied to the control gate 14 of the selected cell 10 causes the semiconductive source-drain path of the selected cell 10 to be conductive. Therefore, the source 11 of the selected cell 10 is at the same potential (Vss) as the drain 12 of that cell 10. The preselected second programming voltage Vss must differ sufficiently from the first preselected programming voltage Vpp that excess electrons will migrate, perhaps by Fowler-Nordheim tunneling, to the selected floating-gate conductor 13 and, as a result, program that selected floating-gate conductor 13. The third and fourth preselected voltages (Vhs) should be placed on the deselected wordlines 15 and the deselected source-column and/or drain-column lines 17/19 prior to placing both the first and second preselected voltages Vpp and Vss on their respective electrodes. The first programming voltage Vpp may be placed on the control-gate conductors 14 in a gradual manner so as to reduce voltage-induced stress on the selected cell 10. The floating gate 13 of the selected cell 10 is charged with electrons during programming, and the electrons in turn render the source-drain path under the floating gate 13 of the selected cell 10 nonconductive, a state which is read as a "zero" bit. Deselected cells have source-drain paths under the floating gate 13 that remain conductive, and those cells are read as "one" bits.

During a flash-erase mode of operation, the source-column decoder 18 functions to apply a positive voltage Vcc (approx. +5V) to all the source-column lines 17. The drain-column decoder 20 functions to leave all drain-column lines 19 floating. The wordline decoder 16 functions to apply a high negative voltage Vee (approx. -11V) to all the wordlines 15. The excess electrons are removed from the floating gates 13 of programmed cells 10.

In the read mode of operation, the wordline decoder 16 functions, in response to wordline address signals on lines 21r, to apply a preselected positive voltage (approx. +3V to +5V, perhaps supply voltage Vcc) to the selected wordline 15, and to apply a low voltage (ground or Vss) to deselected wordlines 15. The drain-column decoder 20 functions, in response to drain-column-address signals on lines 21d, to apply a preselected positive voltage Vsen (approx. +1V to +1.5V) to the selected drain column 19 and to allow the deselected drain lines to float. The source-column decoder 18 functions to connect all source-column lines 17 to ground (or Vss). The conductive or nonconductive state of the cell 10 connected to the selected drain-column line 19 and the selected wordline 15 is detected by a sense amplifier (not shown) connected to the DATA OUT terminal.

The voltages applied to the source 11 and drain 12 regions in the read example above are interchangeable. In addition, programming and erasing may be performed at the drain region 12 with corresponding changes in voltages, if the device is structured so that tunneling of electrons takes place between the drain region 12 and the floating gate 13. The terms "source" and "drain" as used herein are interchangeable for each mode of operation of the memory array.

For convenience, a table of read, write and flash erase voltages is given in the TABLE I below:

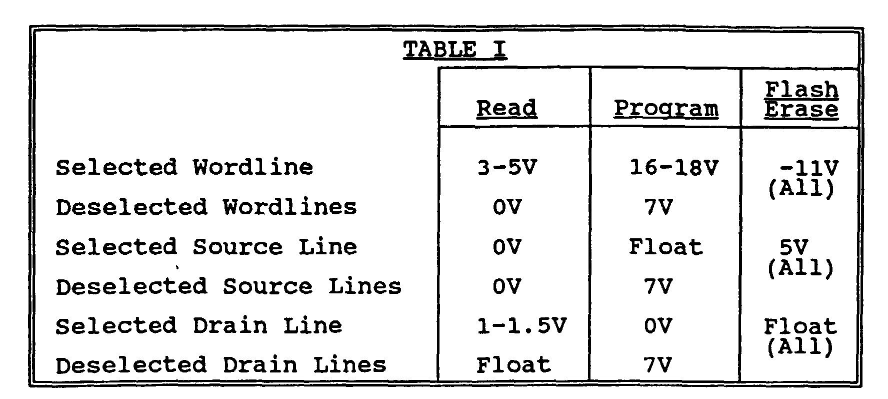

The wordline decoder 16 includes wordline-driver circuits 22 that, in response to signals from lines 21r and from Read/Write/Erase control circuit 23, apply appropriate voltages Vpp, Vhs, Vcc or Vss to wordlines 15 during program-, erase- and read-mode operations. The wordline-decoder circuit 16, including the wordline driver circuits 22, may have parts located remotely from each other and from the memory array. In a segmented memory array, corresponding wordlines 15 of the segments may be connected in parallel and the wordline-driver circuit 22 may drive the parallel connection of wordlines 15.

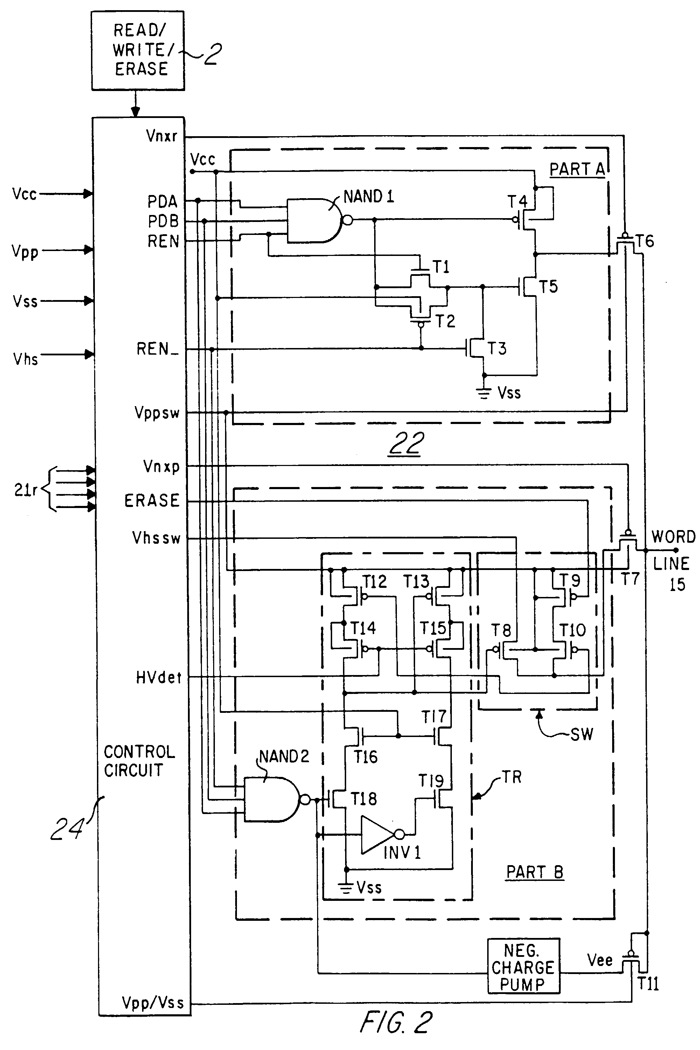

Referring now to FIG. 2, the wordline-driver circuit 22 of this invention includes subcircuits designated PART A and PART B. The signals at the Vnxr, PDA, PDB, REN, REN_, Vnxp, and ERASE terminals of the wordline-driver circuit 22 of FIG. 2 are furnished by control circuit 24 using signals derived from the input signals from lines 21r and from the Read/Write/Erase control circuit 23. The PART A subcircuit is used to drive the WORDLINE terminal 15 during read-mode operation. It is desirable that the PART A subcircuit be capable of operating at a relatively high speed of operation. The PART B subcircuit is used to drive the WORDLINE terminal 15 during program-mode operations, those operations generally requiring higher voltages than those of read-mode operation. Because of the low voltages required for read-mode operation, the transistors T1-T5 of the PART A subcircuit may be constructed with the minimum-length lithographic dimensions (e.g., with the shortest possible channel-length) used to construct the memory cells of the integrated-circuit device. Use of channel-lengths substantially equal to the minimum-length lithographic dimensions increases speed of operation, or permits the PART A subcircuit to drive a higher capacitance associated with the WORDLINE terminal 15. The transistors T8-T10 and T12-T19 used in the PART B subcircuit, as well as switching transistors T6-T7 and T11, generally require larger dimensions (longer channels) because of the higher voltages used in that PART B subcircuit and transistor T6-T7 and T11. Transistors T6-T19 may, for example, have channel-lengths in the range of perhaps one to two times the minimum lithographic dimension used for manufacture of the memory cell array. However, the PART B subcircuit may be located remotely on a common substrate from the PART A subcircuit and from the memory array transistors 10 for the purpose of minimizing the total area used by the entire memory chip. In addition, the transistors T6-T19 may have thicker gate insulators, or oxides, than the transistors of the PART A subcircuit and the memory transistors 10.

In reference to the PART A subcircuit of FIG. 2, the NAND element, designated NAND1, has three input terminals connected to terminals PDA, PDB and REN of control circuit 24, and has an output terminal connected to commonly connected source-drain terminals of N-channel transistor T1 and of P-channel transistor T2. The tank (P-type well in substrate) of P-channel transistor T2 is connected to terminal Vcc. The gate terminal of N-channel transistor T1 is also connected to terminal REN. The gate terminal of P-channel transistor T2 is connected to terminal REN_, and to the gate terminal of N-channel transistor T3. The other common source-drain terminal of N-channel transistor T1 and P-channel transistor T2 is connected to a source-drain terminal of transistor T3. The other source-drain terminal of transistor T3 is connected to reference potential Vss, indicated as ground. The output terminal of NAND1 element is also connected to the gate terminal of P-channel transistor T4. A source-drain terminal and the tank of P-channel transistor T4 are connected to terminal Vcc. The other source-drain terminal of transistor T4 is connected to a source-drain terminal of N-channel transistor T5. The output of the PART A subcircuit is taken from the common source-drain terminals of transistors T4 and T5 and is connected to a source-drain terminal of a switch, shown as P-channel transistor T6. The gate terminal of N-channel transistor T5 is connected to the commonly connected source-drain terminals of transistors T1, T2 and T3. The other source-drain terminal of N-channel transistor T5 is connected to reference voltage Vss.

The other source-drain terminal of P-channel switching transistor T6 is connected to the WORDLINE terminal. The gate terminal of P-channel transistor T6 is connected to read-enable-signal terminal Vnxr. The tank of P-channel transistor T6 is connected to terminal Vppsw.

A circuit similar to the PART A subcircuit of FIG. 2 is described in the aforementioned U.S. Patent No. 4,820,941, issued April 11, 1989 and assigned to Texas Instruments Incorporated.

The output of the PART B subcircuit of FIG. 2 is connected to one source-drain terminal of P-channel switching transistor T7. P-channel transistor T7 has a gate terminal connected to program-enable-signal terminal Vnxp, and another source-drain terminal connected to terminal WORDLINE.

The output of the PART B subcircuit is taken from one of the source-drain terminals of P-channel transistor T8. The tank of P-channel transistor T8 is connected to terminal Vppsw. The other source-drain terminal of P-channel transistor T8 is connected to terminal Vhssw, as is one source-drain terminal of P-channel transistor T9. The other source-drain terminal of P-channel transistor T9 is connected to a source-drain terminal of P-channel transistor T10. The other source-drain terminal of P-channel transistor T10 is connected to the commonly connected source-drain terminals of P-channel transistors T7 and T8. The gate terminal of P-channel transistor T9 is connected to terminal ERASE.

Referring briefly to the erasing subcircuit of the driver circuit 22, a source-drain terminal and the gate terminal of P-channel switching transistor T11 are connected to the terminal designated WORDLINE. The other source-drain terminal of P-channel transistor T11 is connected to the output of a negative voltage supply designated, NEG. CHARGE PUMP. The NEG. CHARGE PUMP voltage supply provides a pulsed negative voltage Vee during erasure. When not providing the negative voltage pulse, the output of the NEG. CHARGE PUMP voltage supply provides a high impedance at its output terminal. A separate NEG. CHARGE PUMP voltage supply may be formed with each PART B subcircuit, or, where several driver circuits 22 are formed to serve segments of a memory array, for example, one NEG. CHARGE PUMP voltage supply may be used for several driver circuits 22. The tank of transistor T11 is connected to voltage Vpp during read- and program-mode operations and to reference potential Vss during erase-mode operation.

Referring now to the translator subcircuit TR of the PART B subcircuit of FIG. 2, P-channel transistors T12 and T13 each have a source-drain terminal connected to terminal Vppsw. The other source-drain terminal of P-channel transistor T12 is connected to a source-drain terminal of P-channel transistor T14. The other source-drain terminal of P-channel transistor T13 is connected to a source-drain terminal of P-channel transistor T15. The other source-drain terminal of P-channel transistor T14 is connected to one source-drain terminal of N-channel transistor T16. The other source-drain terminal of N-channel transistor T16 is connected to a source-drain terminal of N-channel transistor T18. The other source-drain terminal of N-channel transistor T17 is connected to a source-drain terminal of N-channel transistor T19. The other source-drain terminals of N-channel transistors T18 and T19 are connected to reference potential Vss.

A first output of the PART B subcircuit is taken from commonly connected source-drain terminals of P-channel transistor T14 and N-channel transistor T16. The first output is also connected to the gate terminal of P-channel transistor T13. The second output of the subcircuit TR is taken from commonly connected source-drain terminals of P-channel transistor T15 and N-channel transistor T17. The second output is also connected to the gate terminal of P-channel transistor T12. The gate terminals of P-channel transistors T14 and T15 are connected to terminal HVdet. The gate terminals of N-channel transistors T16 and T17 are connected to terminal Vcc.

The first and second outputs of the subcircuit TR are connected to the gate terminals of transistors T8 and T10 respectively of switching subcircuit SW.

The tanks of P-channel transistors T8, T9, T10, T12 and T13 are connected to terminal Vppsw. The tank of P-channel transistor T14 is connected to the commonly connected source-drain terminal of P-channel transistors T12 and T14. The tank of P-channel transistor T15 is connected to the commonly connected source-drain terminals of P-channel transistors T13 and T15.

The NAND element designated NAND2 has three inputs connected to terminals PDA, PDB and REN_, respectively. The output of the NAND2 element is connected to provide an enabling signal to the gate terminal of N-channel transistor T18 and, through inverter circuit designated INV1, to provide an inverted enabling signal to the gate terminal of N-channel transistor T19. The output of the NAND2 element is also connected to an input of the negative voltage supply designated NEG. CHARGE PUMP.

During read-mode operation, voltage supplies connected to the Vppsw, Vhssw and Vcc terminals may have the same value (about 5 volts). The signal voltage applied to the Vnxp terminal may also be about 5 volts, which causes device T7 to isolate PART B of the driver circuit from the WORDLINE terminal. The signal voltage applied to the Vnxr terminal is about -4 volts, allowing both high-level voltage (Vcc) and low-level voltage (ground or 0 volts) to be transferred to the WORDLINE terminal by PART A of the driver circuit. The signal at the REN terminal is equal to the voltage (about 5 volts) at the Vcc terminal. The signal at the REN_ terminal, which is the converse of the signal at the REN terminal, is at ground (Vss or 0 volts). The signal at the REN terminal enables the NAND1 element. The NAND1 element decodes the signals PDA and PDB from a wordline select circuit (not shown). The signal at the REN_ terminal disables the NAND2 element, preventing the rest of the PART B subcircuit from switching. A high-speed read-mode operation is generally desired for driver circuitry connected to the WORDLINE terminal during reading of selected wordlines. Therefore, devices T4, T5 and T6 should be chosen to drive the WORDLINE terminal of the memory array rapidly.

During program- and erase-mode operations, the signal at the REN_ terminal is high (about 5 volts), and the signal at the REN terminal is low (0 volts or ground). The low signal at the REN terminal disables the NAND1 element, which prevents the PART A circuitry from switching. The high signal at the REN_ terminal enables the NAND2 element. The NAND2 element decodes signals PDA and PDB from a wordline decoder circuit (not shown).

During program-mode operation, the Vnxr terminal is at about 18 volts (Vpp), which causes device T6 to isolate PART A subcircuit from the WORDLINE terminal (the WORDLINE terminal is either at about 18 volts or at about 7 volts during program-mode operation). It is noted here that devices T4 and T5 are nonconductive during program-mode operation, which allows a maximum of Vpp-(Vcc plus one diode voltage drop) as the breakdown voltage that may exist on device T6.

During erase-mode operation on a selected wordline, the Vnxr terminal is at ground (0 volts), which causes device T6 to isolate PART A subcircuit from the WORDLINE terminal. The WORDLINE terminal of the driver circuit 22 is at about -11 volts during erase-mode operation on a selected WORDLINE. However, during an erase-mode operation in which the wordline connected to a driver circuit 22 is deselected, the WORDLINE terminal is at Vcc (about 5 volts). Therefore, T6 is conductive during erase-mode operation of the driving circuit on a deselected wordline, but both devices T4 and T5 are nonconductive, which isolates the PART A subcircuit from the WORDLINE terminal. The sources 11/drains 12 of devices T4 and T5 never see a voltage level lower than Vss plus a P-channel voltage threshold. Therefore, the voltage breakdown requirement of T4 is reduced and the relevant PN junction of T5 is not forward biased.

During program-mode operation, the PART B subcircuit is enabled by a high signal (about 5 volts) at the REN_ terminal, by Vpp (about 18 volts) and by Vhs (about 7 volts). The output of the NAND2 element is either at ground (0 volts) or at Vcc (about 5 volts). These outputs will become, at the WORDLINE terminal, either Vss (ground or volts), Vpp (pulsed to about 18 volts), or Vhssw (switched to about 7 volts), when translated by the translator subcircuit TR (including devices T12, T13, T14, T15, T16, T17, T18, T19 and INV1). The signal at the HVdet terminal changes from Vss (0V) to Vcc (about 5 volts) during program-mode operation. Isolation devices T14, T15, T16, and T17 act to reduce the voltage applied to translator subcircuit TR devices, thereby decreasing the "field-plate" or "gated-diode" breakdown voltage requirements for construction of the field-effect transistors of that circuit. Translator subcircuit TR switches high voltage Vpp during program-mode operation using signal inputs from the NAND2 element having potentials equal to Vss and supply voltage-level-signal Vcc. The signal at the Vnxp terminal is at ground (0 volts) during program-mode operation, causing switching transistor T7 to conduct.

Optional switching circuit SW (including devices T8, T9 and T10) allows the switched half-select voltage Vhssw to be switched to the WORDLINE terminal. Depending on whether T8 is conductive (deselected wordline) or T10 is conductive (selected wordline), the WORDLINE terminal is either at Vhs (7 volts) or at Vpp (18 volts), respectively.

During erase-mode operation, voltage supplies at terminals Vhssw and Vppsw are at 5 volts. The negative charge pump is enabled if the WORDLINE terminal is connected to a selected wordline. Device T8 is nonconductive because of the 5 volt signal from the output of translator circuit TR. Device T9 is nonconductive because of a 5 volt signal from the ERASE terminal of control circuit 24. The signal at the Vnxp terminal is at ground (0 volts). Therefore, the WORDLINE terminal is pumped through device T11. If the WORDLINE terminal is connected to a deselected wordline, the negative pump is disabled and the voltage at the WORDLINE terminal is pulled to the value of the supply voltage Vcc at the Vhssw terminal, (about 5 volts) by devices T7 and T8.

During read- and erase-mode operations, the signal at the HVdet terminal is at ground (0 volts) and, therefore, the translator subcircuit TR does not have a floating node. During program-mode operation, the signal at the HVdet terminal is also at ground (0 volts) until the time that Vpp reaches a voltage higher than 10 volts. At that time, a detector circuit (not shown) causes the signal at the HVdet terminal to go high (i.e., about 5 volts), allowing the translator subcircuit TR to operate correctly during the time periods in which Vpp is less than 10 volts, but preventing a large breakdown voltage during the time periods in which Vpp is greater than 10 volts.

For convenience, the input voltages for driver circuit 22 are given in TABLE II below:

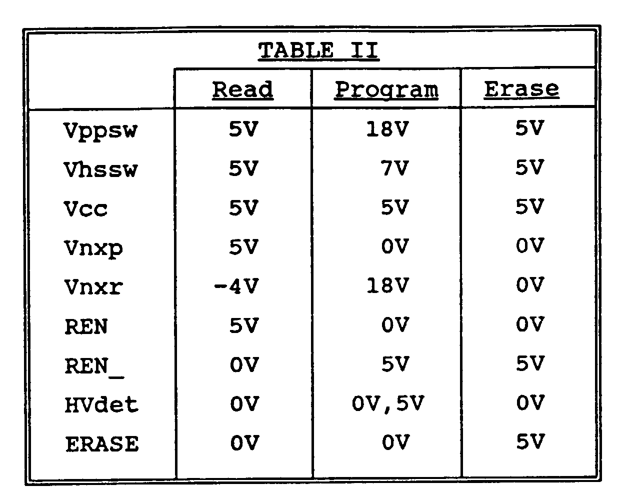

While this invention has been described with respect to an illustrative embodiment, this description is not intended to be construed in a limiting sense. Upon reference to this description, various modifications of the illustrative embodiment, as well as other embodiments of the invention, will be apparent to persons skilled in the art. It is contemplated that the appended claims will cover any such modifications or embodiments that fall within the scope of the invention.

## Claims

1. A non-volatile memory device comprising a wordline and a circuit (22) for applying supply and programming voltages to said wordline (15), said circuit comprising:
a control circuit (24) for respectively providing reading and programming control signals and for respectively providing reference, supply and programming voltages at a plurality of outputs;
a read-mode subcircuit (PART A) having an input connected to one (REN) of said plurality of outputs of said control circuit (24) and having an output for supplying said supply voltage in response to said reading and programming control signals;
a first switch (T6) directly connected between said output of said read-mode subcircuit (PART A) and said wordline (15), said first switch (T6) having a control input connected to one (Vnrx) of said outputs of said control circuit (24);
a program-mode subcircuit (PART B) having an input connected to one (REN_) of said plurality of outputs of said control circuit (24) and having an output for supplying said programming voltage in response to said reading and programming control signals; and
a second switch (T7) directly connected between said output of said program-mode subcircuit (PART B) and said wordline (15), said second switch (T7) having a control input connected to one (Vnxp) of said outputs of said control circuit (24).

2. The non-volatile memory device of claim 1, wherein said program-mode subcircuit (PART B) includes
a translator subcircuit (TR) having an input connected to one of said outputs of said control circuit (24), said translator subcircuit (TR) having an output; and
a switching circuit (SW) having a control input connected to said output of said translator subcircuit (TR), having an input connected to an output of said control circuit (24) providing said programming voltage, and having an output connected to said output of said program-mode subcircuit (PART B).

3. The non-volatile memory of claim 1, wherein said program-mode subcircuit (PART B) includes a translator subcircuit (TR) having a supply voltage input connected to one of said outputs of said control circuit (24), having at least one programming voltage input connected to one of said outputs of said control circuit (24), and having an output and includes a switching subcircuit (SW) having an input connected to said output of said translator subcircuit (TR), wherein said translator subcircuit (TR) translates said supply voltage input to a said programming voltage output signal at said output of said translator subcircuit (TR).

4. The non-volatile memory of claim 1, wherein said program-mode subcircuit (PART B) and said memory array are formed on a substrate and wherein said program-mode subcircuit (PART B) is formed on said substrate remotely from said memory cell array.

5. The non-volatile memory of claim 1, wherein said read-mode subcircuit (PART A) and said memory array are formed on a substrate and wherein said read-mode subcircuit (PART A) is formed on said substrate remotely from said memory cell array.

6. The non-volatile memory of claim 1, wherein said program-mode subcircuit (PART B) includes a translator subcircuit (TR) having first and second outputs and having an enabling input and an inverted enabling input, said enabling and inverted enabling inputs derived from said control circuit (24), said translator subcircuit (TR) comprising:
a first transistor (T12) of a first conductivity type having first and second source-drains and a gate, said first source-drain connected to the control circuit output (Vppsw) providing said programming voltage;
a second transistor (T13) of said first conductivity-type having first and second source-drains and a gate, said first source-drain of said second transistor (T13) connected to the control circuit output (Vppsw) providing said programming voltage;
a third transistor (T14) of said first conductivity-type having first and second source-drains and a gate, having said first source-drain of said third transistor (T14) connected to said second source-drain of said first transistor (T12), and having said gate of said third transistor (T14) connected to one (HVdet) of said outputs of said control circuit (24);
a fourth transistor (T15) of said first conductivity-type having first and second source-drains and a gate, having said first source-drain of said fourth transistor (T15) connected to said second source-drain of said second transistor (T13), and having said gate of said fourth transistor (T15) connected to one (HVdet) of said outputs of said control circuit (24);
a fifth transistor (T16) of a second conductivity-type, opposite said first conductivity-type, having first and second source-drains and a gate, having said first source-drain of said fifth transistor (T16) connected to said second source-drain of said third transistor (T14), to said gate of said second transistor (T13), and to said first output of said translator subcircuit (TR) and having said gate of said fifth transistor (T16) connected to said supply voltage;
a sixth transistor (T17) of said second conductivity-type having first and second source-drains and a gate, having said first source-drain of said sixth transistor (T17) connected to said second source-drain of said fourth transistor, to said gate of said first transistor (T12), and to said second output of said translator subcircuit (TR) and having said gate of said sixth transistor (T17) connected to said supply voltage;
a seventh transistor (T18) of said second conductivity-type having first and second source-drains and a gate, having said first source-drain of said seventh transistor (T18) connected to said second source-drain of said fifth transistor (T16), having said second source-drain of said seventh transistor (T18) connected to said reference voltage, and having said gate of said seventh transistor (T18) connected to said enabling input;
an eighth transistor (T19) of said second conductivity-type having first and second source-drains and a gate, having said first source-drain of said eighth transistor (T19) connected to said second source-drain of said sixth transistor (T17), having said second source-drain of said eighth transistor (T19) connected to said reference voltage, and having said gate of said eighth transistor connected to said inverted enabling input; and
a switch circuit (SW) connected to said output of said translator subcircuit (TR) for connecting one of said outputs of said control circuit (24) to said wordline (15).

7. The non-volatile memory of claim 1, wherein said control circuit (24) also provides a half-select voltage at one of its outputs and wherein said program-mode subcircuit includes:
a translator subcircuit (PART B) having an input connected to one of said outputs of said control circuit (24), said translator subcircuit (TR) having two outputs; and
a switching circuit (SW) having two control inputs respectively connected to said two outputs of said translator subcircuit, having two inputs respectively connected to two of said outputs of said control circuit (24) providing said programming voltage and said half-select voltage, and having an output connected to said output of said program-mode subcircuit (PART B).

8. The non-volatile memory of claim 1, wherein said control circuit (24) also provides a half-select voltage at one (Vhssw) of its outputs and wherein said program-mode subcircuit includes:
a translator subcircuit (TR) having an input connected to one of said outputs of said control circuit (24), said translator subcircuit having first and second outputs; and
a switching circuit (SW) comprising:
a first transistor (T8) having first and second source-drains and a gate, said gate connected to said first output of said translator subcircuit (TR) and said first source-drain connected to the output (Vhssw) of said control circuit (24) providing said half-select voltage; and
a second transistor (T10) having first and second source-drains and a gate, said gate of said second transistor (T10) connected to said second output of said translator subcircuit (TR), said first source-drain of said second transistor (T10) connected to the output (Vppsw) of said control circuit (24) providing said programming voltage, said second second source-drain of said second transistor (T10) connected to said second source-drain of said first transistor (T8) and to said output of said program-mode subcircuit (PART B).

9. The non-volatile memory of claim 1, wherein said circuit (22) also applies erasing voltages to said wordline (15), wherein said control circuit (24) also provides a half-select voltage and an erase signal at two of its outputs (Vhssw, ERASE) and wherein said program-mode subcircuit (PART B) includes:
a translator subcircuit (TR) having an input connected to one of said outputs of said control circuit (24), said translator subcircuit (TR) having first and second outputs; and
a switching circuit (SW) comprising:
a first transistor (T8) having first and second source-drains and a gate, said gate connected to said first output of said translator subcircuit (TR) and said first source-drain connected to the output of said control circuit (24) providing said half-select voltage (Vhssw),
a second transistor (T10) having first and second source-drains and a gate, said gate of said second transistor connected to said second output of said translator subcircuit, said second source-drain of said second transistor (T10) connected to said second source-drain of said first transistor (T8) and to said output of said program-mode subcircuit (PART B); and
a third transistor (T9) having first and second source-drains and a gate, said gate of said third transistor (T9) connected to the output (ERASE) of said control circuit (24) providing said erase signal, said first source-drain of said third transistor (T9) connected to the output (Vppsw) of said control circuit (24) providing said programming voltage, said second source-drain of said third transistor (T9) connected to said first source-drain of said second transistor (T10).

10. The non-volatile memory of claim 1, wherein said first switch (T6) and said second switch (T7) are gated field-effect transistors.

11. The non-volatile memory of claim 1, wherein said first switch (T6) is a field-effect transistor having first and second source-drains and a gate, wherein said first source-drain is connected to said output of said read-mode subcircuit (PART A), said second source-drain is connected to said wordline (15), and said gate is connected to one (Vnxr) of said outputs of said control circuit (24).

12. The non-volatile memory of claim 1, wherein said second switch (T7) is a field-effect transistor having first and second source-drains and a gate, wherein said first source-drain is connected to said output of said program-mode subcircuit (PART B), said second source-drain is connected to said wordline (15), and said gate is connected to one (Vnxp) of said outputs of said control circuit (24).

13. The non-volatile memory of claim 1, wherein said circuit (22) also applies erasing voltages to said wordline (15) and wherein said circuit (22) further includes:
a negative charge pump having a control input and having an erasing voltage output, said control input connected to a signal derived from said control circuit (24); and
a third switch (T11) connected between said erasing voltage output of said negative charge pump and said wordline (15), said third switch (T11) having a control input connected to one (Vpp/Vss) of said outputs of said control circuit (24).

14. The non-volatile memory of claim 1, wherein said circuit (22) also applies erasing voltages to said wordline (15) and wherein said circuit (22) further includes:
a negative charge pump having a control input and having an erasing voltage output, said control input connected to a signal derived from said control circuit (24); and
a field-effect transistor (T11) having first and second source-drains and a gate, wherein said first source-drain is connected to said erasing voltage output of said negative charge pump, said second source-drain is connected to said wordline (15), and said gate is connected to one (Vpp/Vss) of said outputs of said control circuit (24).

## Patentansprüche

1. Nichtflüchtige Speichervorrichtung mit einer Wortleitung und einer Schaltung (22) zum Anlegen von Versorgungs- und Programmierspannungen an die Wortleitung (15), wobei die Schaltung enthält:
eine Steuerschaltung (24) zum Liefern von Lese- und Programmier-Steuersignalen und zum Liefern von Referenz-, Versorgungs- und Programmierspannungen an mehreren Ausgängen;
eine Lesemodus-Teilschaltung (TEIL A) mit einem Eingang, der mit einem (REN) der mehreren Ausgänge der Steuerschaltung (24) verbunden ist, und einem Ausgang zum Abgeben der Versorgungsspannung abhängig von den Lese- und Programmier-Steuersignalen;
einen ersten Schalter (T6), der direkt zwischen den Ausgang der Lesemodus-Teilschaltung (TEIL A) und die Wortleitung (15) geschaltet ist, wobei der erste Schalter (T6) einen Steuereingang aufweist, der mit einem (Vnrx) der Ausgänge der Steuerschaltung (24) verbunden ist;
eine Programmodus-Teilschaltung (TEIL B) mit einem Eingang, der mit einem (REN_) der mehreren Ausgänge der Steuerschaltung (24) verbunden ist, und einen Ausgang zum Liefern der Programmierspannung abhängig von den Lese- und Programmier-Steuersignalen aufweist; und
einen zweiten Schalter (T7), der direkt zwischen den Ausgang der Programmodus-Teilschaltung (TEIL B) und die Wortleitung (15) geschaltet ist, wobei der zweite Schalter (T7) einen Steuereingang aufweist, der mit einem (Vnxp) der Ausgänge der Steuerschaltung (24) verbunden ist.

2. Nichtflüchtige Speichervorrichtung nach Anspruch 1, bei welcher die Programmodus-Teilschaltung (TEIL B) folgendes enthält:
eine Übersetzungsteilschaltung (TR) mit einem Eingang, der mit einem der Ausgänge der Steuerschaltung (24) verbunden ist, wobei die Übersetzungsteilschaltung (TR) einen Ausgang aufweist;
und eine Schaltanordnung (SW) mit einem Steuereingang, der mit dem Ausgang der Übersetzungsteilschaltung (TR) verbunden ist und einen Eingang aufweist, der mit einem Ausgang der Steuerschaltung (24) verbunden ist, der die Programmierspannung liefert, sowie einen Ausgang aufweist, der mit dem Ausgang der Programmodus-Teilschaltung (TEIL B) verbunden ist.

3. Nichtflüchtige Speichervorrichtung nach Anspruch 1, bei welcher die Programmodus-Teilschaltung (TEIL B) eine Übersetzungsteilschaltung (TR) enthält, die einen Versorgungsspannungseingang enthält, der mit einem der Ausgänge der Steuerschaltung (24) verbunden ist, wenigstens einen Programmierspannungseingang aufweist, der mit einem der Ausgänge der Steuerschaltung (24) verbunden ist, und einen Ausgang sowie eine Teil-Schaltanordnung (SW) aufweist, die mit einem mit einem Ausgang der Übersetzungsteilschaltung (TR) verbundenen Eingang versehen ist, wobei die Übersetzungsteilschaltung (TR) den Versorgungsspannungseingang zu einem Programmierspannungsausgangssignal an dem Ausgang der Übersetzungsteilschaltung (TR) übersetzt.

4. Nichtflüchtige Speichervorrichtung nach Anspruch 1, bei welcher die Programmodus-Teilschaltung (TEIL B) und die Speichermatrix auf einem Substrat gebildet sind und bei welcher die Programmodus-Teilschaltung (TEIL B) auf dem Substrat von der Speicherzellenmatrix entfernt gebildet ist.

5. Nichtflüchtige Speichervorrichtung nach Anspruch 1, bei welcher die Lesemodus-Teilschaltung (TEIL A) und die Speichermatrix auf einem Substrat gebildet sind und bei welcher die Lesemodus-Teilschaltung (TEIL A) auf dem Substrat von der Speicherzellenmatrix entfernt gebildet ist.

6. Nichtflüchtige Speichervorrichtung nach Anspruch 1, bei welcher die Programmodus-Teilschaltung (TEIL B) eine Übersetzungsteilschaltung (TR) mit einem ersten und einem zweiten Ausgang sowie einem Freigabeeingang und einem invertierten Freigabeeingang enthält, wobei der Freigabeeingang und der invertierte Freigabeeingang von der Steuerschaltung (24) hergeleitet sind, wobei die Übersetzungsteilschaltung (TR) enthält:
einen ersten Transistor (T12) eines ersten Leitungstyps mit einem ersten und einem zweiten Source-Drain-Anschluß sowie einem Gate-Anschluß, wobei der erste Source-Drain-Anschluß mit dem Steuerschaltungsausgang (Vppsw) verbunden ist, der die Programmierspannung liefert;
einen zweiten Transistor (T13) des ersten Leitungstyps mit einem ersten und einem zweiten Source-Drain-Anschluß sowie einem Gate-Anschluß, wobei der erste Source-Drain-Anschluß des zweiten Transistors (T13) mit dem Steuerschaltungsausgang (Vppsw) verbunden ist, der die Programmierspannung liefert;
einen dritten Transistor (T14) des ersten Leitungstyps mit einem ersten und einem zweiten Source-Drain-Anschluß sowie einem Gate-Anschluß, wobei der erste Source-Drain-Anschluß des dritten Transistors (T14) mit dem zweiten Source-Drain-Anschluß des ersten Transistors (T12) verbunden ist, wobei der Gate-Anschluß des dritten Transistors (T14) mit einem (HVdet) der Ausgänge der Steuerschaltung (24) verbunden ist;
einen vierten Transistor (T15) des ersten Leitungstyps mit einem ersten und einem zweiten Source-Drain-Anschluß sowie einem Gate-Anschluß, wobei der erste Source-Drain-Anschluß des vierten Transistors (T15) mit dem zweiten Source-Drain-Anschluß des zweiten Transistors (T13) verbunden ist und der Gate-Anschluß des vierten Transistors (T15) mit einem (HVdet) der Ausgänge der Steuerschaltung (24) verbunden ist;
einen fünften Transistor (T16) eines dem ersten Leitungstyp entgegengesetzten zweiten Leitungstyps mit einem ersten und einem zweiten Source-Drain-Anschluß sowie einem Gate-Anschluß, wobei der erste Source-Drain-Anschluß des fünften Transistors (T16) mit dem zweiten Source-Drain-Anschluß des dritten Transistors (T14), mit dem Gate-Anschluß des zweiten Transistors (T13) und dem ersten Ausgang der Übersetzungsteilschaltung (TR) verbunden ist, während der Gate-Anschluß des fünften Transistors (T16) an die Versorgungsspannung gelegt ist;
einen sechsten Transistor (T17) des zweiten Leitungstyps mit einem ersten und einem zweiten Source-Drain-Anschluß sowie einem Gate-Anschluß, wobei der erste Source-Drain-Anschluß des sechsten Transistors (T17) mit dem zweiten Source-Drain-Anschluß des vierten Transistors, dem Gate-Anschluß des ersten Transistors (T12) und dem zweiten Ausgang der Übersetzungsteilschaltung (TR) verbunden ist, während der Gate-Anschluß des sechsten Transistors (T17) an die versorgungsspannung gelegt ist;
einen siebten Transistor (T18) des zweiten Leitungstyps mit einem ersten und einem zweiten Source-Drain-Anschluß sowie einem Gate-Anschluß, wobei der erste Source-Drain-Anschluß des siebten Transistors (T18) mit dem zweiten Source-Drain-Anschluß des fünften Transistors (T16) verbunden ist, der zweite Source-Drain-Anschluß des siebten Transistors (T18) an die Referenzspannung gelegt ist und der Gate-Anschluß des siebten Transistors (T18) mit dem Freigabeeingang verbunden ist;
einen achten Transistor (T19) des zweiten Leitungstyps mit einem ersten und einem zweiten Source-Drain-Anschluß sowie einem Gate-Anschluß, wobei der erste Source-Drain-Anschluß des achten Transistors (T19) mit dem zweiten Source-Drain-Anschluß des sechsten Transistors (T17) verbunden ist, der zweite Source-Drain-Anschluß des achten Transistors (T19) an die Referenzspannung gelegt ist und der Gate-Anschluß des achten Transistors mit dem invertierten Freigabeeingang verbunden ist und
eine Schaltanordnung (SW), die mit dem Ausgang der Übersetzungsteilschaltung (TR) verbunden ist, um einen der Ausgänge der Steuerschaltung (24) mit der Wortleitung (15) zu verbinden.

7. Nichtflüchtige Speichervorrichtung nach Anspruch 1, bei welcher die Steuerschaltung (24) an einem ihrer Ausgänge eine halbe Wählspannung liefert und wobei die Programmodus-Teilschaltung folgendes enthält:
eine Übersetzungs-Teilschaltung (TEIL B) mit einem Eingang, der mit einem der Ausgänge der Steuerschaltung (24) verbunden ist, wobei die Übersetzungsteilschaltung (TR) zwei Ausgänge aufweist; und
eine Schaltanordnung (SW) mit zwei Steuereingängen, die jeweils mit den zwei Ausgängen der Übersetzungsteilschaltung verbunden sind und die zwei Eingänge aufweist, die jeweils mit zwei Ausgängen der Steuerschaltung (24) verbunden sind, die die Programmierspannung und die halbe Wählspannung liefern, sowie einen Ausgang aufweist, der mit dem Ausgang der Programmodus-Teilschaltung (TEIL B) verbunden ist.

8. Nichtflüchtige Speichervorrichtung nach Anspruch 1, bei welcher die Steuerschaltung (24) außerdem an einem ihrer Ausgänge eine halbe Wählspannung (Vhssw) liefert und wobei die Programmodus-Teilschaltung folgendes enthält:
eine Übersetzungsteilschaltung (TR) mit einem Eingang, der mit einem der Ausgänge der Steuerschaltung (24) verbunden ist, wobei die Übersetzungsteilschaltung einen ersten und einen zweiten Ausgang aufweist; und
eine Schaltanordnung (SW) mit:
einem ersten Transistor (T8) mit einem ersten und einem zweiten Source-Drain-Anschluß sowie einem Gate-Anschluß, wobei der Gate-Anschluß mit dem ersten Ausgang der Übersetzungsteilschaltung (TR) verbunden ist und der erste Source-Drain-Anschluß mit dem die halbe Wählspannung abgebenden Ausgang (Vhssw) der Steuerchaltung (24) verbunden ist; und
einem zweiten Transistor (T10) mit einem ersten und einem zweiten Source-Drain-Anschluß sowie einem Gate-Anschluß, wobei der Gate-Anschluß des zweiten Transistors (T10) mit dem zweiten Ausgang der Übersetzungsteilschaltung (TR) verbunden ist, der erste Source-Drain-Anschluß des zweiten Transistors (T10) mit dem die Programmierspannung liefernden Ausgang (Vppsw) der Steuerschaltung (24) verbunden ist, und der zweite Source-Drain-Anschluß des zweiten Transistors (T10) mit dem zweiten Source-Drain-Anschluß des ersten Transistors (T8) und dem Ausgang der Programmodus-Teilschaltung (TEIL B) verbunden ist.

9. Nichtflüchtige Speichervorrichtung nach Anspruch 1, bei welcher die Schaltung (22) außerdem Löschspannungen an die Wortleitung (15) anlegt, wobei die Steuerschaltung (24) außerdem an zwei ihrer Ausgänge (Vhssw, ERASE) eine halbe Wählspannung bzw. ein Löschsignal liefert und wobei die Programmodus-Teilschaltung (TEIL B) folgendes enthält:
eine Übersetzungsteilschaltung (TR) mit einem an einem der Ausgänge der Steuerschaltung (24) angeschlossenen Eingang sowie einem ersten und einem zweiten Ausgang; und
eine Schaltanordnung (SW) mit:
einem ersten Transistor (T8) mit einem ersten und einem zweiten Source-Drain-Anschluß sowie einem Gate-Anschluß, wobei der Gate-Anschluß mit dem ersten Ausgang der Übersetzungsteilschaltung (TR) verbunden ist und der erste Source-Drain-Anschluß mit dem Ausgang der Steuerchaltung (24) verbunden ist, der die halbe Wählschaltung (Vhssw) liefert,
einem zweiten Transistor (T10) mit einem ersten und einem zweiten Source-Drain-Anschluß sowie einem Gate-Anschluß, wobei der Gate-Anschluß des zweiten Transistors mit dem zweiten Ausgang der Übersetzungsteilschaltung verbunden ist, der zweite Source-Drain-Anschluß des zweiten Transistors (T10) mit dem zweiten Source-Drain-Anschluß des ersten Transistors (T8) und mit dem Ausgang der Programmodus-Teilschaltung (TEIL B) verbunden ist; und
einem dritten Transistor (T9) mit einem ersten und einem zweiten Source-Drain-Anschluß sowie einem Gate-Anschluß, wobei der Gate-Anschluß des dritten Transistors (T9) mit dem Ausgang (ERASE) der Steuerschaltung (24) verbunden ist, der das Löschsignal liefert, der erste Source-Drain-Anschluß des dritten Transistors (T9) mit dem Ausgang (Vppsw) der Steuerschaltung (24) verbunden ist, der die Programmierspannung liefert, und der zweite Source-Drain-Anschluß des dritten Transistors (T9) mit dem ersten Source-Drain-Anschluß des zweiten Transistors (T10) verbunden ist.

10. Nichtflüchtige Speichervorrichtung nach Anspruch 1, bei welcher der erste Schalter (T6) und der zweite Schalter (T7) geschaltete Feldeffekttransistoren sind.

11. Nichtflüchtige Speichervorrichtung nach Anspruch 1, bei welcher der erste Schalter (T6) ein Feldeffekttransistor mit einem ersten und einem zweiten Source-Drain-Anschluß sowie einem Gate-Anschluß ist, wobei der erste Source-Drain-Anschluß mit dem Ausgang der Lesemodus-Teilschaltung (TEIL A) verbunden ist, der zweite Source-Drain-Anschluß mit der Wortleitung (15) verbunden ist und der Gate-Anschluß mit einem (Vnxr) der Ausgänge der Steuerschaltung (24) verbunden ist.

12. Nichtflüchtige Speichervorrichtung nach Anspruch 1, bei welcher der zweite Schalter (T7) ein Feldeffekttransistor mit einem ersten und einem zweiten Source-Drain-Anschluß sowie einem Gate-Anschluß ist, wobei der erste Source-Drain-Anschluß mit dem Ausgang der Programmodus-Teilschaltung (TEIL B) verbunden ist, der zweite Source-Drain-Anschluß mit der Wortleitung (15) verbunden ist und der Gate-Anschluß mit einem (Vnxp) der Ausgänge der Steuerschaltung (24) verbunden ist.

13. Nichtflüchtige Speichervorrichtung nach Anspruch 1, bei welcher die Schaltung (22) ferner Löschspannungen an die Wortleitung (15) anlegt und die Schaltung (22) ferner enthält:
eine negative Ladungspumpe mit einem Steuereingang und einem Löschspannungsausgang, wobei der Steuereingang mit einem von der Steuerschaltung (24) abgeleiteten Signal verbunden ist; und
einen dritten Schalter (Tll), der zwischen den Löschspannungsausgang der negativen Ladungspumpe und die Wortleitung (15) geschaltet ist, wobei der dritte Schalter (Tll) einen Steuereingang aufweist, der mit einem (Vpp/Vss) der Ausgänge der Steuerschaltung (24) verbunden ist.

14. Nichtflüchtige Speichervorrichtung nach Anspruch 1, bei welcher die Schaltung (22) außerdem Löschspannungen an die Wortleitung (15) anlegt wobei die Schaltung (22) ferner enthält:
eine negative Ladungspumpe mit einem Steuereingang und einem Löschspannungsausgang, wobei der Steuereingang mit einem aus der Steuerschaltung (24) abgeleiteten Signal verbunden ist; und
einen Feldeffekttransistor (T11) mit einem ersten und einem zweiten Source-Drain-Anschluß sowie einem Gate-Anschluß, wobei der erste Source-Drain-Anschluß mit dem Löschspannungsausgang der negativen Ladungspumpe verbunden ist, der zweite Source-Drain-Anschluß mit der Wortleitung (15) verbunden ist und der Gate-Anschluß mit einem (Vpp/Vss) der Ausgänge der Steuerschaltung (24) verbunden ist.

## Revendications

1. Dispositif de mémoire non volatile comprenant une ligne de transmission de mots et un circuit (22) pour appliquer des tensions d'alimentation et de programmation à ladite ligne de transmission de mots (15), ledit circuit comprenant :
un circuit de commande (24) pour délivrer respectivement des signaux de commande de lecture et de programmation et pour délivrer respectivement des tensions de référence, d'alimentation et de programmation sur une pluralité de sorties;
un sous-circuit de mode de lecture (PARTIE A) ayant une entrée connectée à l'une (REN) de ladite pluralité de sorties dudit circuit de commande (24) et comportant une sortie pour délivrer ladite tension d'alimentation en réponse auxdits signaux de commande de lecture et de programmation;
un premier interrupteur (T6) connecté directement entre ladite sortie dudit sous-circuit du mode de lecture (PARTIE A) et ladite ligne de transmission de mots (15), ledit premier interrupteur (.T6) ayant une entrée de commande connectée à l'une (Vnrx) desdites sorties dudit circuit de commande (24);
un sous-circuit de mode de programme (PARTIE B) ayant une entrée connectée à l'une (REN_) de ladite pluralité de sorties dudit circuit de commande (24) comportant une sortie servant à délivrer ladite tension de programmation en réponse auxdits signaux de commande de lecture et de programmation; et
un second interrupteur (T7) connecté directement entre ladite sortie dudit sous-circuit de mode de programme (PARTIE B) et ladite ligne de transmission de mots (15), ledit second interrupteur (T7). possédant une entrée de commande connectée à l'une (Vnxp) desdites sorties dudit circuit de commande (24).

2. Dispositif de mémoire non volatile selon la revendication 1, dans lequel ledit sous-circuit de mode de programme (PARTIE B) comprend
un sous-circuit de conversion (TR) comportant une entrée connectée à l'une desdites sorties dudit circuit de commande (24), ledit sous-circuit de conversion (TR) comportant une sortie; et
un circuit de commutation (SW) comportant une entrée de commande connectée à ladite sortie dudit sous-circuit de conversion (TR), possédant une entrée connectée à une sortie dudit circuit de commande (24) délivrant ladite tension de programmation, et possédant une sortie connectée à ladite sortie dudit sous-circuit de mode de programme (PARTIE B).

3. Mémoire non volatile selon la revendication 1, dans laquelle ledit sous-circuit de mode de programme (PARTIE B) comprend un sous-circuit de conversion (TR) dont une entrée de tension d'alimentation est connectée à l'une desdites sorties dudit circuit de commande (24), possédant au moins une entrée de tension de programmation connectée à l'une desdites sorties dudit circuit de commande (24), et possédant une sortie, et inclut un sous-circuit de commutation (SW) comportant une entrée connectée à ladite sortie dudit sous-circuit de conversion (TR), ledit sous-circuit de conversion (TR) convertissant ladite tension d'alimentation envoyée en ledit signal de tension de sortie de programmation présent sur ladite sortie dudit sous-circuit de conversion (TR).

4. Mémoire non volatile selon la revendication 1, dans laquelle ledit sous-circuit de mode de programme (PARTIE B) et ledit réseau de mémoire sont formés sur un substrat, et ledit sous-circuit de mode de programme (PARTIE B) est formé sur ledit substrat à distance dudit réseau de cellules de mémoire.

5. Mémoire non volatile selon la revendication 1, dans laquelle ledit sous-circuit de mode de lecture (PARTIE A) et ledit réseau de mémoire sont formés sur un substrat, et ledit sous-circuit de mode de lecture (PARTIE A) est formé sur ledit substrat à distance dudit réseau de cellules de mémoire.

6. Mémoire non volatile selon la revendication 1, dans laquelle ledit sous-circuit de mode de programme (PARTIE B) inclut un sous-circuit de conversion (TR) comportant des première et seconde sorties et possédant une entrée de validation et une entrée de validation inversée, lesdites entrées de validation et de validation inversée s'étendant à partir dudit circuit de commande (24), ledit sous-circuit de conversion (TR) comprenant :
un premier transistor (T12) ayant un premier type de conductivité et comportant des premier et second ensembles source-drain et une grille, ledit premier ensemble source-drain étant connecté à la sortie (Vppsw) du circuit de commande, qui délivre ladite tension de programmation;
un second transistor (T13) possédant ledit premier type de conductivité et comportant des premier et second ensembles source-drain et une grille, ledit premier ensemble source-drain dudit second transistor (T13) est connecté à la sortie (Vppsw) du circuit de commande délivrant ladite tension de programmation;
un troisième transistor (T14) possédant ledit premier type de conductivité et comportant des premier et second ensembles source-drain et une grille, dans lequel ledit premier ensemble source-drain dudit troisième transistor (T14) est connecté audit second ensemble source-drain dudit premier transistor (T1-2) et dans lequel ladite grille dudit troisième transistor (T14) est connectée à l'une (HVdet) desdites sorties dudit circuit de commande (24);
un quatrième transistor (T15) possédant ledit premier type de conductivité et portant des premier et second ensembles source-drain et une grille, ledit premier ensemble source-drain dudit quatrième transistor (T15) étant connecté audit second ensemble source-drain dudit second transistor (T13) et ladite grille dudit quatrième transistor (T15) étant connectée à l'une (HVdet) desdites sorties dudit circuit de commande (24);
un cinquième transistor (T16) possédant un second type de conductivité opposé audit premier type de conductivité et comportant des premier et second ensembles source-drain et une grille, ledit premier ensemble source-drain dudit cinquième transistor (T16) étant connecté audit second ensemble source-drain dudit troisième transistor (T14), à ladite grille dudit second transistor (T13) et à ladite première sortie dudit sous-circuit de conversion (TR), et ladite grille dudit cinquième transistor (T16) étant connectée à ladite tension d'alimentation;
un sixième transistor (T17) possédant le second type de conductivité et comportant des premier et second ensembles source-drain et une grille, ledit premier ensemble source-drain dudit sixième transistor (T17) étant connecté audit second ensemble source-drain dudit quatrième transistor, à ladite grille dudit premier transistor (T12) et à ladite seconde sortie dudit sous-circuit de conversion (TR), et ladite grille dudit sixième transistor (T17) étant connectée à ladite tension d'alimentation;
un septième transistor (T18) possédant ledit second type de conductivité et comprenant des premier et second ensembles source-drain et une grille, ledit premier ensemble source-drain dudit septième transistor (T18) étant connecté audit second ensemble source-drain dudit cinquième transistor (T16), ledit second ensemble source-drain dudit septième transistor (T18) étant connecté à ladite tension de référence et ladite grille dudit septième transistor (T18) étant connectée à ladite entrée de validation;
un huitième transistor (T19) possédant ledit second type de conductivité et comportant des premier et second ensembles source-drain et une grille, ledit premier ensemble source-drain dudit huitième transistor (T19) étant connecté audit second ensemble source-drain dudit sixième transistor (T17), ledit second ensemble source-drain dudit huitième transistor (T19) étant connecté à ladite tension de référence, et ladite grille dudit huitième transistor étant connectée à ladite entrée de validation inversée; et
un circuit de commutation (SW) connecté à ladite sortie dudit circuit de conversion (TR) pour connecter l'une desdites sorties dudit circuit de commande (24) à ladite ligne de transmission de mots (15).

7. Mémoire non volatile selon la revendication 1, dans laquelle ledit circuit de commande (24) fournit également une tension de demi-sélection au niveau de l'une de ses sorties, et dans laquelle ledit sous-circuit de mode de programme comprend :
un sous-circuit de conversion (PARTIE B) possédant une entrée raccordée à l'une desdites sorties dudit circuit de commande (24), ledit sous-circuit de conversion (TR) possédant deux sorties; et
un circuit de commutation (SW) comportant deux entrées de commande connectées respectivement auxdites deux sorties dudit sous-circuit de conversion, et comportant deux entrées connectées respectivement à deux desdites sorties dudit circuit de commande (24) délivrant ladite tension de programmation et ladite tension de demi-sélection, et comportant une sortie connectée à ladite sortie dudit sous-circuit de mode de programmation (PARTIE B).

8. Mémoire non volatile selon la revendication 1, dans laquelle ledit circuit de commande (24) délivre également une tension de demi-sélection sur l'une (Vhssw) de ses sorties, et dans laquelle ledit sous-circuit de mode de programme comprend :
un sous-circuit de conversion (TR) possédant une entrée connectée à l'une desdites sorties dudit circuit de commande (24), ledit sous-circuit de conversion possédant des première et seconde sorties; et
un circuit de commutation (SW) comprenant :
un premier transistor (T8) ayant des premier et second ensembles source-drain et une grille, ladite grille étant connectée à ladite première sortie dudit sous-circuit de conversion (TR) et ledit premier ensemble source-drain étant connecté à la sortie (Vhssv) dudit circuit de commande (24) délivrant ladite tension de demi-sélection; et
un second transistor (T10) comportant des premier et second ensembles source-drain et une grille, ladite grille dudit second transistor (T10) étant connectée à ladite seconde sortie dudit sous-circuit de conversion (TR), ledit premier ensemble source-drain dudit second transistor (T10) connecté à la sortie (Vppsw) dudit circuit de commande (24) fournissant ladite tension de programmation, ledit second ensemble source-drain dudit second transistor (T10) étant connecté audit second ensemble source-drain dudit premier transistor (T8) et à ladite sortie dudit sous-circuit de mode de programme (PARTIE B).

9. Mémoire non volatile selon la revendication 1, dans laquelle ledit circuit (22) applique également des tensions d'effacement à ladite ligne de transmission de mots (15), ledit circuit de commande (24) délivrant également une tension de demi-sélection et un signal d'effacement sur deux de ses sorties (Vhssw, EFFACEMENT), et dans lequel ledit sous-circuit de mode de programme (PARTIE B) comprend :
un sous-circuit de conversion (TR) possédant une entrée connectée à l'une desdites sorties dudit circuit de commande (24), ledit sous-circuit de conversion (TR) comportant des première et seconde sorties; et
un circuit de commutation (SW) comprenant :
un premier transistor (T8) comportant des premier et second ensembles source-drain et une grille, ladite grille étant connectée à ladite première sortie dudit sous-circuit de conversion (TR) et ledit premier ensemble source-drain étant connecté à la sortie dudit circuit de commande (24) délivrant lesdites tensions de demi-sélection (Vhssw),
un second transistor (T10) comportant des premier et second ensembles source-drain et une grille, ladite grille dudit second transistor étant connectée à ladite seconde sortie dudit sous-circuit de conversion, ledit second ensemble source-drain dudit second transistor (T10) étant connecté audit second ensemble source-drain dudit premier transistor (T8) et à ladite sortie dudit sous-circuit de mode de programme (PARTIE B); et
un troisième transistor (T9) comportant des premier et second ensembles source-drain et une grille, ladite grille du troisième transistor (T9) connectée à la sortie (EFFACEMENT) dudit circuit de commande (24) délivrant ledit signal d'effacement, ledit premier ensemble source-drain dudit troisième transistor (T9) connecté à la sortie (Vppsw) dudit circuit de commande (24) délivrant ladite tension de programmation, ledit second ensemble source-drain dudit troisième transistor (T9) étant connecté audit premier ensemble source-drain dudit second transistor (T10).

10. Mémoire non volatile selon la revendication 1, dans laquelle ledit premier interrupteur (T6) et ledit second interrupteur (T7) sont des transistors à effet de champ à déclenchement contrôlé.

11. Mémoire non volatile selon la revendication 1, dans laquelle ledit premier interrupteur (T6) est un transistor à effet de champ comportant des premier et second ensembles source-drain et une grille, ledit premier ensemble source-drain étant connecté à ladite sortie dudit sous-circuit de mode de lecture (PARTIE A), ledit second ensemble source-drain étant connecté à ladite ligne de transmission de mots (15), ladite grille étant connectée à l'une (Vnxr) desdites sorties dudit circuit de commande (24).

12. Mémoire non volatile selon la revendication 1, dans laquelle ledit second interrupteur (T7) est un transistor à effet de champ possédant des premier et second ensembles source-drain et une grille, ledit premier ensemble source-drain étant connecté à ladite sortie dudit sous-circuit de mode de programmation (PARTIE B), ledit second ensemble source-drain étant connecté à ladite ligne de transmission de mots (15) et ladite grille étant connectée à l'une (Vnxp) desdites sorties dudit circuit de commande (24).

13. Mémoire non volatile selon la revendication 1, dans laquelle ledit circuit (22) applique également des tensions d'effacement à ladite ligne de transmission de mots (15) et dans laquelle ledit circuit (22) comprend en outre :
une pompe de charge négative ayant une entrée de commande et ayant une sortie de tension d'effacement, ladite entrée de commande étant connectée à un signal dérivé dudit circuit de commande (24); et
un troisième interrupteur (T11) connecté entre ladite sortie de tension d'effacement de ladite pompe de charge négative et ladite ligne de transmission de mots (15), ledit troisième interrupteur (T11) ayant une entrée de commande connectée à l'une (Vpp/Vss) desdites sorties dudit circuit de commande (24).

14. Mémoire non volatile selon la revendication 1, dans laquelle ledit circuit (22) applique également des tensions d'effacement à ladite ligne de transmission de mots (15), et dans laquelle ledit circuit (22) comprend en outre :
une pompe de charge négative ayant une entrée de commande et ayant une sortie de tension d'effacement, ladite entrée de commande étant connectée à un signal dérivé dudit circuit de commande (24); et
un transistor à effet de champ (T11) comportant des premier et second ensembles source-drain et une grille, ledit premier ensemble source-drain étant connecté à ladite sortie de tension d'effacement de ladite pompe de charge négative, ledit second ensemble source-drain étant connecté à ladite ligne de transmission de mots (15), et ladite grille étant connectée à l'une (Vpp/Vas) desdites sorties dudit circuit de commande (24).
